Europäisches Patentamt

European Patent Office

Office européen des brevets

(19)

(11) Veröffentlichungsnummer: **0 113 872**
**A1**

## (12) EUROPÄISCHE PATENTANMELDUNG

(21) Anmeldenummer: **83112490.4**

(22) Anmeldetag: **12.12.83**

(51) Int. Cl.³: **H 02 J 3/18**

(30) Priorität: **14.12.82 JP 217731/82**

(43) Veröffentlichungstag der Anmeldung: **25.07.84**
**Patentblatt 84/30**

(84) Benannte Vertragsstaaten: **CH DE FR GB IT LI NL SE**

(71) Anmelder: **FUJI ELECTRIC CO. LTD., 1-1,
Tanabeshinden, Kawasaki-ku, Kawasaki 210 (JP)**

(72) Erfinder: **Konishi, Shigeo, 46-5, Toyoda 2-chome,
Hino-shi Tokyo (JP)**
Erfinder: **Shiraishi, Hitotaka, 11-8, Tamadaira 3-chome,
Hino-shi Tokyo (JP)**

(74) Vertreter: **Mehl, Ernst, Dipl.-Ing. et al, Postfach 22 01 76,
D-8000 München 22 (DE)**

(54) Verfahren zum Steuern von Thyristorschaltgeräten für Phasenschieberkondensatoren an einem elektrischen Netz.

(57) Um schädliche Resonanzerscheinungen bei Schalten von netzgespeisten Induktivitäten (3) in Reihe mit Kondensatoren (4) durch Zünden von Thyristorschaltgeräten (5) zu beliebigen Zeitpunkten zu vermeiden, wird die Spannung an Kondensatoren und Thyristorschaltgeräten nach Größe und Polarität erfaßt und bei einer bestimmten Abweichung der jeweiligen Kondensatorspannung von einem konstanten Höchstwert ein kurzzeitiges Zünden des Thyristorschaltgerätes bewirkt, um die Kondensatorspannung durch einen kurzzeitigen Resonanzstrom ($i_c$) auf den Höchstwert anzuheben, so daß ihr Höchstwert stets vor dem eigentlichen Einschalten der Kondensatoren gewährleistet ist.

EP 0 113 872 A1

FUJI ELECTRIC CO., Ltd.      Mein Zeichen
Kawasaki / Japan           VPA 82 P 8578 E

Verfahren zum Steuern von Thyristorschaltgeräten für Phasenschieberkondensatoren an einem elektrischen Netz

Die Erfindung betrifft ein Verfahren zum Steuern von Thyristorschaltgeräten nach dem Oberbegriff des Patentanspruchs 1 und eine Thyristorschalteinrichtung zur Durchführung des Verfahrens.

Bei Thyristorschalteinrichtungen, die je Strang als Thyristorschaltgerät eine Antiparallelschaltung von Thyristoren aufweisen, das im Sekundärkreis eines an ein Netz anschaltbaren Transformators jeweils in Reihe mit einem Phasenschieberkondensator und einer Induktivität liegt, erfolgt das jeweilige Zünden eines Thyristorschaltgerätes beim Nulldurchgang der an diesem anliegenden Spannung. In diesem Fall wird ein durch die Resonanz des Phasenschieberkondensators und der Induktivität verursachter Stromstoß unterdrückt.

Wenn der Nulldurchgang der am Thyristorschaltgerät anliegenden Spannung um 90° gegen die Speisespannung verschoben ist, d.h. im Maximum einer Speisespannungshalbwelle auftritt, dann liegt am Kondensator das Maximum der Speisespannung an und die durch die Resonanz von Kondensator und Induktivität bedingte transiente Erscheinung wird von extrem kleinem Wert bleiben, d.h. der transiente Strom ist lediglich das 1,1fache des normalen Maximalwertes, was bedeutet, daß die Spannung und der Strom des Kondensators bei eingeschaltetem Thyristorschaltgerät nahezu sinusförmig verlaufen. Jedoch wird die Ladung des Kondensators bei nichtgezündeten Thyristoren allmählich abgebaut infolge des Entladungswiderstandes des Kondensators und der Spannungsteilerwiderstände im Thyristorschaltgerät.

Ot 2 Ca / 09.11.1983

Wenn auf diese Weise die Spannung am Thyristorschaltgerät Null wird, zu einem Zeitpunkt, wo die Spannung am Kondensator nur noch 50 % des Maximalwertes beträgt, fließt beim Einschalten des Thyristorschaltgerätes infolge der Reihenresonanz von Kondensator und Induktivität ein starker transienter Strom, dessen Größe bestimmt wird durch die Ladespannung des Kondensators zum Zündzeitpunkt des Thyristorschaltgerätes und die Größe der Induktivität, die die Thyristorzündphase bestimmen.

Im allgemeinen beträgt die Impedanz der Induktivität 6 bis 14 % der Impedanz des Kondensators. Wenn aber die Thyristoren zum vorgenannten Zeitpunkt gezündet werden, wird eine Impedanz der Induktivität von nur 3 bis 6 % der Impedanz des Kondensators wirksam, so daß der Spitzenwert des transienten Stromes das Zweifache des Maximums des normalen Stromes im Kondensator erreicht, wobei die transienten Erscheinungen abhängig von der Stromkreiskonstante über die Dauer mehrerer Zyklen auftreten.

Es ist daher notwendig, die Stromaufnahmefähigkeit des Thyristorschaltgerätes für den Fall zu bemessen, bei dem der Kondensator im entladenen Zustand geschaltet wird. Dies erfordert große Schaltgeräte und hat außerdem den Nachteil, daß der wesentlich größere transiente Strom unerwünschte Störungen im Netz beim Zünden des Thyristorschaltgerätes hervorrufen kann.

Der Erfindung liegt die Aufgabe zugrunde, ein Steuerverfahren zu schaffen, um schädliche transiente Erscheinungen zu vermeiden und mit klein dimensionierten, einfach aufgebauten Thyristorschaltern auszukommen.

Die Lösung der Aufgabe gelingt durch die kennzeichnenden Merkmale des Patentanspruchs 1.

Ein Ausführungsbeispiel einer Thyristorschalteinrichtung zur Durchführung des Verfahrens nach der Erfindung ist in der Zeichnung vereinfacht dargestellt und nachfolgend näher erläutert. Es zeigen

Fig. 1 eine Schaltung zur Steuerung von Thyristorschaltgeräten für die Reihenschaltung von Kondensatoren und Induktivitäten auf der Sekundärseite eines an ein Netz anschaltbaren Transformators,

Fig. 2 bis 11 zeitliche Abläufe von Spannungen und Strömen sowie Schaltzuständen von Schaltelementen im Steuerkreis des Thyristorschaltgerätes eines Stranges.

An ein nicht dargestelltes Netz ist über einen Schalter 1 ein Transformator 2 angeschlossen, an dessen Sekundärseite die Reihenschaltung einer Induktivität 3 mit einem phasenverschiebenden Kondensator 4 und einem geerdeten Thyristorschaltgerät 5 liegt. Das Thyristorschaltgerät 5 weist in bekannter Weise antiparallele Thyristoren auf, die zu gegebener Zeit gemeinsam in den stromdurchlässigen Zustand gesteuert werden.

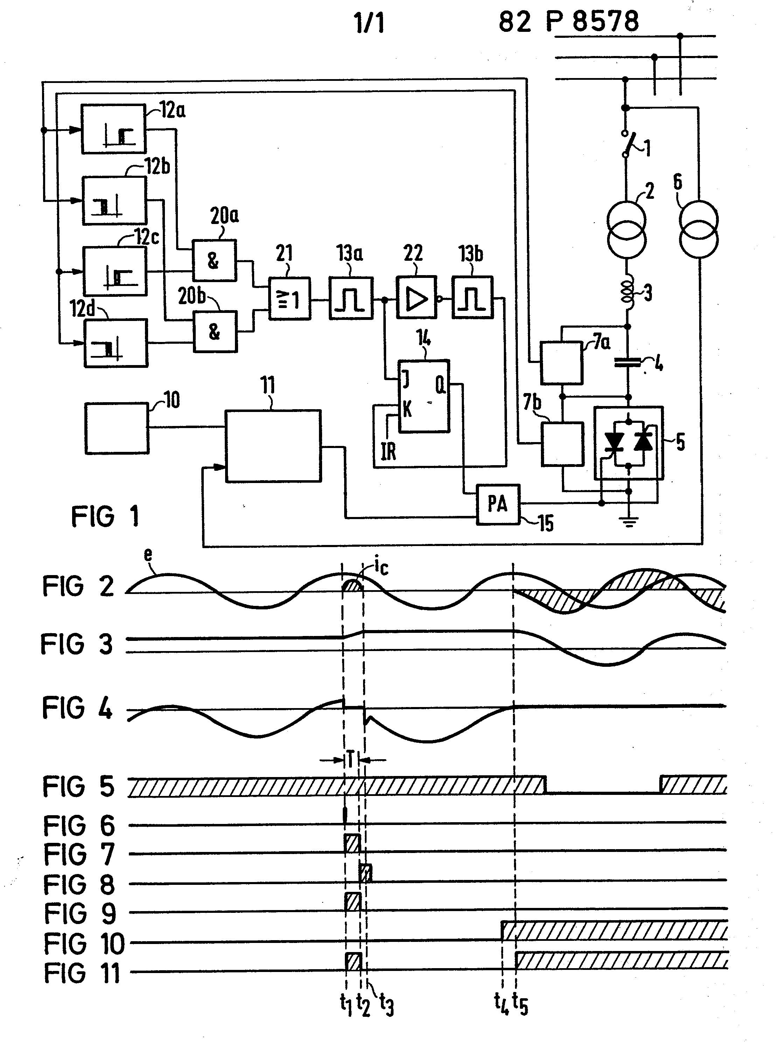

Zur Steuerung des Thyristorschaltgerätes 5 wird die am Kondensator 4 gemäß Fig. 3 anliegende Spannung $U_4$ durch einen Spannungsdetektor 7a erfaßt, der seinerseits mit zwei Komparatoren 12a und 12b verbunden ist, die zur Anzeige der Kondensatorspannung und zur Anzeige der Polarität der Kondensatorladung dienen. Sie sind mit UND-Gattern 20a bzw. 20b verbunden und bestimmen, welches der UND-Gatter durchlässig wird.

Zur Erfassung der am gesperrten Thyristorschaltgerät 5 anliegenden Spannung $U_5$ (Fig. 4) ist diesem ein Spannungsdetektor 7b zugeordnet, der seinerseits mit Komparatoren 12c und 12d verbunden ist, die die Spannung $U_5$ anzeigen sowie die Polarität der Spannung $U_5$ erfassen und entsprechende

0113872

- 4 -        VPA 82 P 8578 E

Steuervorgänge einleiten. Der Komparator 12c gibt bei positiver Polarität der Spannung $U_4$ über das UND-Gatter 20a, der Komparator 12d bei negativer Polarität der Spannung $U_4$ über das UND-Gatter 20b sowie ein den beiden UND-Gattern nachgeschaltetes ODER-Gatter 21 ein Signal, das über einen monostabilen Multivibrator 13a dem Eingang J einer Flip-Flop-Schaltung 14 und über eine dem Multivibrator 13a nachgeschaltete Reihenschaltung eines NICHT-Gatters 22 und eines monostabilen Multivibrators 13b dem Eingang K der Flip-Flop-Schaltung 14 zugeführt wird. Der Ausgang Q der Flip-Flop-Schaltung 14 ist auf den einen Eingang eines Impulsverstärkers 15 geführt, dessen zweiter Eingang von einem Synchronrechner 11 beeinflußt ist. Der Ausgang des Impulsverstärkers 15 gibt Zündimpulse auf die Thyristoren des Thyristorschaltgerätes 5 in nachfolgend noch näher erläuterter Weise. Hierzu wird der Synchronrechner 11 und der Impulsverstärker 15 von einem an das Netz angeschlossenen Hilfstransformator 6 gespeist. Der Synchronrechner 11 ist außerdem mit einem Befehlsschalter 10 verbunden.

Es wird eine Hilfsladesteuermethode beschrieben, durch die das Thyristorschaltgerät 5 bei normaler Arbeitsweise für eine bestimmte Periode stromdurchlässig gesteuert wird, um die Ladung des Kondensators 4 zu ergänzen und seine Spannung auf den dem Maximum der Speisespannung entsprechenden konstanten Wert zu halten (unabhängig vom normalen Ein-Aus-Steuerbefehl für das Thyristorschaltgerät 5), sobald während des stromsperrenden Zustandes des Thyristorschaltgerätes 5 die Spannung des Kondensators 4 unter einen bestimmten Wert absinkt.

In den Fig. 2 bis 11 sind die zeitlichen Abläufe der besagten Vorgänge dargestellt und es zeigen

Fig. 2 den zeitlichen Ablauf der Speisespannung e und das Auftreten des Kondensatorstromes $i_c$ im Zeitraum $t_1$ bis $t_3$,

Fig. 3 die vom Spannungsdetektor 7a erfaßte Spannung $U_4$ am Kondensator,

Fig. 4 die vom Spannungsdetektor 7b erfaßte Spannung $U_5$ am Thyristorschaltgerät,

Fig. 5 das Ausgangssignal am Komparator 12a,

Fig. 6 den Ausgangszustand am Komparator 12c,

Fig. 7 das Ausgangssignal des Multivibrators 13a als "Ein"- Signal für das Thyristorschaltgerät für die Ergänzungsladung im Zeitraum $t_1$ bis $t_2$ (Zeitraum T),

Fig. 8 das Ausgangssignal des Multivibrators 13b zur Beendigung der Ergänzungsladung zum Zeitpunkt $t_3$,

Fig. 9 das Ausgangssignal der Flip-Flop-Schaltung 14 zur Bestimmung der Ergänzungsladung,

Fig. 10 das Einschalt-Signal des Schalters 10 zum Zeitpunkt $t_4$,

Fig. 11 das Signal des Impulsverstärkers 15 als Thyristorzündsignal der Zeitspannen $t_1$-$t_2$ und zum Zeitpunkt $t_5$.


Bei Annahme einer positiven Ladung, d.h. positiver Spannung $U_4$, des Kondensators 4 wird das UND-Gatter 20a durch den Komparator 12a (Fig. 5) vorbereitet. Es steigt die Spannung $U_5$ an den Klemmen des Thyristorschaltgerätes 5 allmählich an und die Spannung $U_4$ am Kondensator 4 nimmt ab. Sobald der positive Wert von $U_5$ den Arbeitspunkt (Ergänzungsladungsansprechwert) des Komparators 12c zur Zeit $t_1$ erreicht, wird die Flip-Flop-Schaltung 14 gesetzt, wodurch das Thyristorschaltgerät 5 zur Zeit $t_1$ eingeschaltet wird. Infolgedessen fließt der durch den Kondensator 4 und die Induktivität 3 erzwungene Resonanzstrom $i_c$ (Fig. 2). Danach wird zur Zeit $t_2$ die Flip-Flop-Schaltung 14 erneut gesetzt, nachdem die Setzdauer T für den Multivibrator 13a (Fig. 7) abgelaufen und das Thyristorschaltgerät 5 gesperrt ist. Demgemäß fließt der dem Betrag einer Halbwelle äquivalente Resonanzstrom solange, bis das Thyristorschaltgerät 5 zur Zeit $t_3$ (bei der der Strom Null wird) gesperrt wird. Zur Zeit $t_3$ ist dann die Spannung $U_4$ gemäß Fig. 3 auf den konstanten höchsten Wert angehoben.

Die Spannung $U_4$ steigt an und fällt ab zwischen dem Ergänzungsansprechwert und dem konstanten Höchstwert auf die
genannte Weise und wird daher immer in der Nähe des Höchstwertes gehalten während des Sperrzustandes des Thyristorschaltgerätes 5. Dies verhindert einen übergroßen vorübergehenden Stromfluß wie bei den bekannten Schaltungen der
eingangs genannten Art.

Wie die Fig. 2 und 7 erkennen lassen, wird die Setzdauer T
des Multivibrators 13a so bestimmt, daß sie nicht länger ist
als die vom Kondensator 4 und der Induktivität 3 abhängige
Dauer des Resonanzflusses. Darüber hinaus ist die Ansprechgröße (Ergänzungsladungsbetrag) der Komparatoren 12c und 12d
so gewählt, daß der transiente Strom bei normaler Tätigkeit,
bei der das Thyristorschaltgerät 5 stromdurchlässig ist,
innerhalb der Toleranz liegt.

Die Setzdauer T gilt wie gesagt auch für die Flip-Flop-
Schaltung (Fig. 9) und den Impulsverstärker 15 (Fig. 11).

Der Multivibrator 13b wird, wie schon erwähnt, gemäß Fig. 8
nach Ablauf von T gesetzt. Vor dem normalen Schalten des
Thyristorschaltgerätes 5 zum Zeitpunkt $t_5$ durch den Impulsverstärker 15 gemäß Fig. 10, bei dem die Verhältnisse gemäß
Fig. 2 eintreten, wird zum Zeitpunkt $t_4$ gemäß Fig. 10 der
Schalter 10 eingeschaltet. Damit wird mit Leichtigkeit die
Kondensatorladespannung ungefähr auf dem konstanten Höchstwert entsprechend dem Scheitelwert der Speisespannung gehalten und somit ein sanftes Arbeiten des Kondensators unter
Vermeidung übermäßiger transienter Ströme bei einer Differenz in den Zeiten des Ansprechens erreicht, und auf diese
Weise eine ökonomisch effiziente Thyristorschalteinrichtung
erhalten.

3 Patentansprüche
11 Figuren

Patentansprüche

1. Verfahren zum Steuern einer Thyristorschalteinrichtung, deren antiparallelen Thyristoren in Reihe mit netzgespeisten Induktivitäten und phasenschiebenden Kondensatoren liegen, d a d u r c h   g e k e n n z e i c h n e t , daß die Spannungen der Kondensatoren (4) und an den Thyristoren getrennt erfaßt und bei Vorliegen von Kondensatorspannungen ($U_4$) bei stromsperrendem Zustand der Thyristoren unter einen dem Scheitelwert der Speisespannung (e) entsprechenden konstanten Höchstwert eine Steuerung der Thyristoren in den stromdurchlässigen Zustand zur Nachladung der Kondensatoren (4) auf den Höchstwert erfolgt, so daß beim normalen Schaltzeitpunkt ($t_5$) der Thyristoren bei Spannungswerten Null ihrer Spannungen ($U_5$) die Spannungen ($U_4$) der Kondensatoren (4) den Höchstwert aufweisen.

2. Verfahren nach Anspruch 1, d a d u r c h   g e k e n n - z e i c h n e t , daß während der Nachladung der Kondensatoren (4) durch einen Resonanzstrom ($i_c$) die zugeordneten Thyristoren (5) zündimpulsfrei bleiben.

3. Thyristorschalteinrichtung zur Durchführung des Verfahrens nach den Ansprüchen 1 und 2, d a d u r c h   g e - k e n n z e i c h n e t , daß die Spannungen an den jeweiligen Kondensatoren (4) und ihren aus antiparallelen Thyristoren bestehenden Thyristorschaltgeräten (5) durch zugeordnete Spannungsdetektoren (7a, 7b) getrennt erfaßt und jeweils einem spannungsanzeigenden Komparator (12a, 12b) sowie jeweils einem die Spannungspolaritäten erfassenden Komparator (12b, 12d) zugeführt sind und die die Spannung erfassenden Komparatoren (12a, 12c) und die die Polarität erfassenden Komparatoren (12b, 12d) jeweils über gemeinsame UND-Gatter (20a, 20b) auf ein ODER-Gatter (21) geführt sind, das ausgangsseitig über einen Multivibrator (13a) mit dem Eingang (J) einer Flip-Flop-Schaltung (14) und über ein NICHT-Gatter (22) in Reihe mit einem zweiten Multivibrator (13b) mit dem Eingang (K) der Flip-Flop-Schaltung verbunden ist, deren Ausgang (Q) an einen Eingang eines auf die Thyristoren des überwachten Thyristorschaltgerätes (5) Zündimpulse gebenden Impulsverstärkers (15) angeschlossen ist, dessen zweiter Eingang mit dem Ausgang eines Synchronrechners (11) verbunden, der einerseits mit einem Befehlsschalter (10) und andererseits mit einem netzgespeisten Hilfstransformator (6) verbunden ist.

0113872

82 P 8578

FIG 1

FIG 2

FIG 3

FIG 4

FIG 5

FIG 6

FIG 7

FIG 8

FIG 9

FIG 10

FIG 11

Office européen
des brevets

**RAPPORT DE RECHERCHE EUROPEENNE**

0113872

Numéro de la demande

EP 83 11 2490

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| X | US-A-4 162 442 (H. FRANK) <br> * Spalte 1, Zeile 54 - Spalte 4, Zeile 31; Figuren 1,2 * | 1-3 | H 02 J 3/18 |
| A | EP-A-0 037 087 (SIEMENS) <br> * Seite 5, Zeile 35 - Seite 9, Zeile 11; Seite 10, Zeile 27 - Seite 11, Zeile 15; Figuren 1,2,4 * | 1,3 | |
| A | FR-A-2 078 243 (ALLMANNA SVENSKA ELEKTRISKA AB) <br> * Seite 3, Zeile 17 - Seite 5, Zeile 33; Figuren 1,2 * | 1 | |
| A | DE-A-2 816 361 (LICENTIA) <br> * Seite 9, Zeile 14 - Seite 10, Zeile 4; Figur 1 * | 1 | |

DOMAINES TECHNIQUES RECHERCHES (Int. Cl. 3)

H 02 J 3

Le présent rapport de recherche a été établi pour toutes les revendications

| Lieu de la recherche | Date d'achèvement de la recherche | Examinateur |
|---|---|---|
| DEN HAAG | 28-03-1984 | POINT A.G.F. |